# EUROPEAN PATENT SPECIFICATION

(11) **EP 2 117 039 B1**
(45) Date of publication and mention of the grant of the patent: **18.03.2015**
(21) Application number: 09158455.7
(22) Date of filing: 22.04.2009
(51) Int. Cl.: H01L 21/335, H01L 29/778

(54) **Semiconductor devices including shallow inplanted regions and methods of forming the same**
Halbleitervorrichtungen mit flachimplantierten Bereichen und Verfahren zur Bildung davon
Dispositifs semi-conducteurs incluant des régions implantées peu profondes et leurs procédés de formation

(30) Priority: 09.05.2008 US 118543
(43) Date of publication of application: 11.11.2009
(73) Proprietor: Cree, Inc., Durham, NC 27703 (US)
(72) Inventor: Sheppard, Scott T, Chapel Hill, NC 27516 (US); Smith, R. Peter, Carraboro, NC 27510 (US); Wu, Yifeng, Goleta, CA 93117 (US); Heikman, Sten, Goleta, CA 93117 (US); Jacob-Mitos, Matthew, Santa Barbara, CA 93105 (US)
(74) Representative: Boult Wade Tennant

(56) References cited:
- US-A1- 2007 158 683
- US-A1- 2007 269 968
- RECHT F ET AL: "Nanoalloyed Ohmic Contacts in A1GaN/GaN HEMTs by Ion Implantation With Reduced Activation Annealing Temperature" IEEE ELECTRON DEVICE LETTERS, IEEE SERVICE CENTER, NEW YORK, NY, US LNKD- DOI:10.1109/LED.2006.870419, vol. 27, no. 4, 1 April 2006 (2006-04-01), pages 205-207, XP001546504 ISSN: 0741-3106
- DENBAARS S ET AL: "Ion Implanted AlGaN-GaN HEMTs With Nonalloyed Ohmic Contacts" IEEE ELECTRON DEVICE LETTERS, IEEE SERVICE CENTER, NEW YORK, NY, US LNKD- DOI:10.1109/LED.2005.846583, vol. 26, no. 5, 1 May 2005 (2005-05-01), pages 283-285, XP011131276 ISSN: 0741-3106

## Description

### STATEMENT OF U.S. GOVERNMENT INTEREST

This invention was made with Government support under Contract No. 4400121759 awarded by the Defense Advanced Research Projects Agency. The US Government has certain rights in the invention.

The present invention relates to semiconductor devices and, more particularly, to semiconductor devices that include implanted regions and related methods.

There is a high level of interest in wide bandgap semiconductor materials such as silicon carbide (2.996 eV for alpha SiC at room temperature) and the Group III nitrides (e.g., 3.36 eV for GaN at room temperature) for high power, high temperature and/or high frequency applications. These materials, typically, have higher electric field breakdown strengths and higher electron saturation velocities as compared to gallium arsenide and silicon.

A device of particular interest for high power and/or high frequency applications is the High Electron Mobility Transistor (HEMT), which is also known as a modulation doped field effect transistor (MODFET). These devices may offer operational advantages under a number of circumstances because a two-dimensional electron gas (2DEG) is formed at the heterojunction of two semiconductor materials with different bandgap energies, and where the smaller bandgap material has a higher electron affinity. The 2DEG is an accumulation layer in the undoped ("unintentionally doped"), smaller bandgap material and can contain a very high sheet electron concentration in excess of, for example, 10¹³ carriers/cm². Additionally, electrons that originate in the wider-bandgap semiconductor transfer to the 2DEG, allowing a high electron mobility due to reduced ionized impurity scattering.

This combination of high carrier concentration and high carrier mobility can give the HEMT a very large transconductance and may provide a strong performance advantage over metal-semiconductor field effect transistors (MESFETs) for high-frequency applications.

High electron mobility transistors fabricated in the gallium nitride/aluminum gallium nitride (GaN/AlGaN) material system have the potential to generate large amounts of RF power because of the combination of material characteristics that includes the aforementioned high breakdown fields, their wide bandgaps, large conduction band offset, and/or high saturated electron drift velocity. In addition, a major portion of the electrons in the 2DEG is attributed to polarization in the AlGaN.

U.S. Patent No. 6,316,793, to Sheppard et al., which is commonly assigned and is incorporated herein by reference, describes a HEMT device having a semi-insulating silicon carbide substrate, an aluminum nitride buffer layer on the substrate, an insulating gallium nitride layer on the buffer layer, an aluminum gallium nitride barrier layer on the gallium nitride layer, and a passivation layer on the aluminum gallium nitride active structure.

In order to provide desired semiconductor properties, it is frequently desirable to dope a semiconductor layer with impurity atoms (i.e. dopants). Doping of semiconductor materials may be performed during and/or after material growth. Impurity atoms may be categorized as n-type or p-type depending on whether the implanted ions act as donors (which increase the number of electrons) or acceptors (which increase the number of holes), respectively, in the doped material. The resulting material may be characterized as n-type or p-type depending on the predominant type of dopants in the material.

Ion implantation is a well-known method of doping a semiconductor layer with impurities. In an ion implantation process, ionized impurity atoms are accelerated under high vacuum through an electric field towards a target layer, where they become implanted. The number of ions directed at a target layer is referred to as the dose, which is typically expressed in ions/cm². The ions are accelerated at an energy level, typically expressed in electron-volts (eV). The distribution of ions in the implanted layer depends on the dose and energy of the implant, sometimes referred to as the implant conditions, as well as the type of ions implanted, the type of material the ions are implanted into, the angle of the implants, and other factors. The implanted ions typically form a concentration distribution that has a peak concentration at a particular depth (i.e., the "implant range").

Ion implantation is useful for selective doping of crystalline material in order to form desired regions in the material, such as p-n junctions, highly conductive contact regions, field spreading regions, etc. Typically, after impurities are implanted into a semiconductor layer, it is desirable to anneal the implanted impurities at a high temperature, i.e. a so-called activation anneal. An activation anneal may repair damage caused by the implantation of high-energy ions into the semiconductor lattice. Implant damage may include, for example, broken and/or rearranged chemical bonds within the semiconductor lattice. The activation anneal may also assist implanted impurity ions in finding a suitable site in the crystal lattice at which the ions may appropriately act as acceptors and/or donors.

In nitride-based HEMT device structures, the source and drain regions are typically formed as implanted regions. However, the anneal conditions (e.g., temperature and/or duration of anneal) used to activate the implanted dopants may be harmful to the nitride epitaxial layers of the device. Thus, for example, devices may exhibit increased sheet resistance in their channel regions following the activation anneal.

US-2007/269968 relates to a method of forming a semiconductor layer on a semiconductor substrate. A mask is formed on the semiconductor layer and ions having a first conductivity type are implanted into the semiconductor layer to form implanted regions. Metal layers are formed on the implanted regions according to the mask. The implanted regions and the metal layers are annealed in a single step to activate the implanted ions in the implanted regions respectively and provide otimic contacts on the implanted regions.

### SUMMARY

The present invention provides a method of forming a semiconductor device in accordance with the claim 1 and a transistor device in accordance with claim 14.

The accompanying drawings, which are included to provide a further understanding of the invention and are incorporated in and constitute a part of this application, illustrate certain embodiment(s) of the invention. In the drawings:
Figures 1A-1E are cross-sectional views illustrating fabrication of a transistor; and
Figures 2 and 3 are cross-sectional views illustrating devices according to some embodiments of the invention; and
Figures 4A and 4B are cross-sectional views illustrating fabrication of a transistor according to further embodiments of the present invention.
Figures 5 to 7 are flowcharts illustrating operations.

Embodiments of the present invention now will be described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

Embodiments of the present invention may be particularly well suited for use in nitride-based HEMTs such as Group III-nitride based devices. As used herein, the term "Group III nitride" refers to those semiconducting compounds formed between nitrogen and the elements in Group III of the periodic table, usually aluminum (A1), gallium (Ga), and/or indium (In). The term also refers to ternary and quaternary compounds such as AIGaN and AlInGaN. As is well understood by those in this art, the Group III elements can combine with nitrogen to form binary (e.g., GaN), ternary (e.g., AlGaN, AlInN), and quaternary (e.g., AlInGaN) compounds. These compounds all have empirical formulas in which one mole of nitrogen is combined with a total of one mole of the Group III elements. Accordingly, formulas such as AlₓGa₁₋ₓN where 0 ≤ x ≤ 1 are often used to describe them.

Embodiments of the present invention utilize a protective layer during implantation of dopant atoms into a semiconductor layer, for example, to provide highly doped source/drain regions of a transistor. The protective layer may remain on the structure during an anneal to activate the implanted dopant atoms to protect the surface of the semiconductor layer. The protective layer may further remain on the semiconductor layer to act as a passivation layer for the semiconductor layer in the completed device.

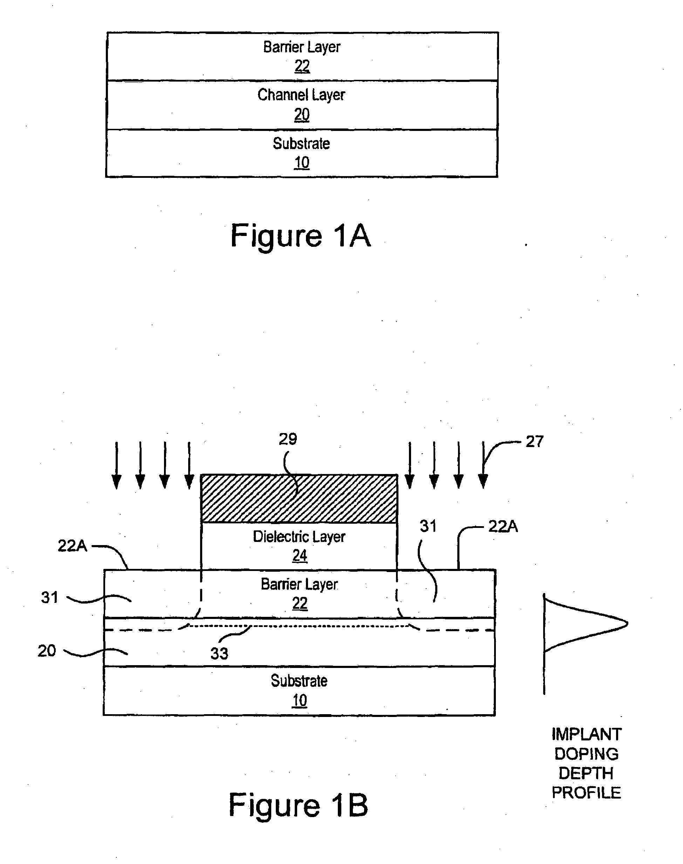

Fabrication of structures, not part of the invention, is schematically illustrated in **Figures 1A-1F**. As seen in **Figure 1A**, a substrate **10** is provided on which nitride based devices may be formed. In particular embodiments of the present invention, the substrate **10** may be a semi-insulating silicon carbide (SiC) substrate that may be, for example, 4H polytype of silicon carbide. Other silicon carbide candidate polytypes include the 3C, 6H, and 15R polytypes. The term "semi-insulating" is used in a relative rather than absolute sense. In particular examples not part of the invention, the silicon carbide bulk crystal has a resistivity equal to or higher than about 1x10⁵ Ω-cm at room temperature.

Optional buffer, nucleation and/or transition layers (not shown) may be provided on the substrate **10**. For example, an AlN buffer layer may be provided to provide an appropriate crystal structure transition between the silicon carbide substrate and the remainder of the device.

Silicon carbide has a much closer crystal lattice match to Group III nitrides than does sapphire (Al₂O₃), which is a very common substrate material for Group III nitride devices. The closer lattice match may result in Group III nitride films of higher quality than those generally available on sapphire. Silicon carbide also has a very high thermal conductivity so that the total output power of Group III nitride devices on silicon carbide is, typically, not as limited by thermal dissipation of the substrate as in the case of the same devices formed on sapphire. Also, the availability of semi-insulating silicon carbide substrates may provide for device isolation and reduced parasitic capacitance. Appropriate SiC substrates are manufactured by, for example, Cree, Inc., of Durham, N.C., the assignee of the present invention.

Although silicon carbide may be used as a substrate material, examples not part of the invention may utilize any suitable substrate, such as sapphire, aluminum nitride, aluminum gallium nitride, gallium nitride, silicon, GaAs, LGO, ZnO, LAO, InP and the like. In some examples not part of the invention, an appropriate buffer layer also may be formed.

Returning to **Figure 1A**, a channel layer **20** is formed on the substrate **10**. The channel layer **20** may be formed on the substrate **10** using buffer layers, transition layers, and/or nucleation layers as described above. The channel layer **20** may be under compressive strain. Furthermore, the channel layer and/or buffer nucleation and/or transition layers may be epitaxially grown by metal-organic chemical vapor deposition (MOCVD) or by other techniques known to those of skill in the art, such as molecular beam epitaxy (MBE), hydride vapor phase epitaxy (HVPE) or other suitable techniques.

In some examples not part of the invention, the channel layer **20** is a Group III-nitride, such as AlₓGa₁₋ₓN where 0 ≤ x < 1, provided that the energy of the conduction band edge of the channel layer **20** is less than the energy of the conduction band edge of the barrier layer **22** at the interface between the channel and barrier layers. In certain examples not part of the invention, x = 0, indicating that the channel layer **20** is GaN. The channel layer **20** may also include other Group III-nitrides such as InGaN, AlInGaN or the like. The channel layer **20** may be undoped ("unintentionally doped") and may be grown to a thickness of greater than about 20 Å. The channel layer **20** may also be a multi-layer structure, such as a superlattice or combinations of GaN, AlGaN or the like.

A barrier layer **22** is formed on the channel layer **20.** The barrier layer **22** may have a bandgap that is greater than the bandgap of the channel layer **20** and the barrier layer 22 may also have a smaller electron affinity than the channel layer **20.** The barrier layer **22** may be epitaxially grown directly on the channel layer **20.** In certain examples not part of the invention, the barrier layer **22** includes AlN, AlInN, AlGaN and/or AlInGaN with a thickness of between about 0.1 nm and about 10 nm. In some examples not part of the invention, the barrier layer may include AlₓGa₁₋ₓN where 0 ≤ x < 0.32. In particular examples not part of the invention, x = 0.22.

While examples not part of the invention are described herein with reference to particular HEMT structures, the present invention should not be construed as limited to such structures. For example, additional layers may be included in the HEMT device. Such additional layers may include a GaN cap layer on the barrier layer. Furthermore, the barrier layer **22** may also be provided with multiple layers. Thus, examples not part of the invention should not be construed as limiting the barrier layer to a single layer but may include, for example, barrier layers having combinations of GaN, AlGaN and/or AlN layers. For example, a GaN, AlN structure may be utilized to reduce or prevent alloy scattering. Thus, examples not part of the invention may include nitride based barrier layers, such nitride based barrier layers may include AlGaN based barrier layers, AlN based barrier layers and combinations thereof.

In particular examples not part of the invention, the barrier layer **22** is thick enough and has a high enough Al composition and doping to induce a significant carrier concentration at the interface between the channel layer **20** and the barrier layer **22** through polarization effects when the barrier layer **22** is buried under ohmic contact metal. Also, the barrier layer **22** should be thick enough to reduce or minimize scattering of electrons in the channel due to ionized impurities deposited at the interface between the barrier layer **22** and a dielectric layer **24 (****Figure 1B****)**.

As noted above, the barrier layer **22** may have a bandgap larger than that of the channel layer **20** and a smaller electron affinity than the channel layer **20.** Accordingly, in certain examples not part of the invention, the barrier layer **22** may include AlGaN, AlInGaN and/or AlN or combinations of layers thereof. The barrier layer **22** should not be so thick as to cause cracking or substantial defect formation therein. In certain examples not part of the invention, the barrier layer **22** is undoped or doped with an n-type dopant to a concentration less than about 1x10¹⁹ cm⁻³. In some examples not part of the invention, the barrier layer **22** includes AlₓGa₁₋ₓN where 0 < x <= 1. In particular examples not part of the invention, the aluminum concentration may be about 25%. However, in other examples not part of the invention, the barrier layer **22** comprises AlGaN with an aluminum concentration of between about 5% and about 100%. In some examples not part of the invention, the aluminum concentration is greater than about 10%.

As shown in **Figure 1B**, a dielectric layer **24** is formed on the barrier layer **22.** The dielectric layer **24** may include silicon nitride (SiₓN_{y}), silicon dioxide (SiO₂), AlSiN, and/or another suitable dielectric material, such as silicon oxynitride (SiON). It will be understood that the terms "SiₓN_{y}," "SiN" and "silicon nitride" are used herein interchangeably to refer to both stoichiometric and non-stoichimetric silicon nitride. Other materials may also be utilized for the dielectric layer **24.** For example, the dielectric layer **24** could also include magnesium oxide, scandium oxide, aluminum oxide and/or aluminum oxynitride. Furthermore, the dielectric layer **24** may be a single layer or may include multiple layers of uniform and/or non-uniform composition. The material of the dielectric layer **24** should be capable of withstanding relatively high temperatures, and should be capable of being removed without significantly damaging the underlying barrier layer **22.**

In general, the dielectric layer **24** may be a dielectric layer that has a relatively high breakdown field strength and that provides a relatively low interface trap density at the interface with an underlying Group III-nitride layer such as the barrier layer **22.** The dielectric layer **24** may have a high etch selectivity with respect to the material of the barrier layer **22,** and may not be reactive to the material of the barrier layer **22.** Moreover, the dielectric layer **24** may have a relatively low level of impurities therein. For example, the dielectric layer **24** may have a relatively low level of hydrogen and other impurities, including oxygen, carbon, fluorine and chlorine. In addition, the dielectric layer **24** may be stable at relatively high temperatures (e.g. >1000 °C) in order to withstand high annealing temperatures used in subsequent process steps.

In particular examples not part of the invention, the dielectric layer **24** includes SiN. The SiN dielectric layer **24** may be formed, for example, by Chemical Vapor Deposition (CVD). The SiN dielectric layer **24** may be stoichiometric (i.e. the ratio of silicon to nitrogen in the material is about 3:4). The stoichiometry of a SiN layer may be adjusted, for example, by adjusting the relative flow rates of SiH₄ and NH₃ source gases in a CVD process. Moreover, when formed at relatively high temperatures, CVD-grown SiN tends to be stoichiometric.

The stoichiometry of a SiN layer may also affect the index of refraction of the layer. In certain examples not part of the invention, a SiN dielectric layer **24** may have an index of refraction at a 633 nm wavelength of from about 1.6 to about 2.2. In particular examples not part of the invention, the index of refraction of a SiN dielectric layer **24** is 1.98 ± 0.05 as measured by ellipsometry. Stoichiometric SiN may also be characterized by its etch rate in a buffered oxide etch (BOE). For example, the etch rate of stoichiometric SiN in BOE is nearly zero.

In some examples not part of the invention, the dielectric layer **24** may be SiO₂. The SiO₂ may be formed by LPCVD and/or MOCVD and may be stoichiometric. In certain examples not part of the invention the present invention, an SiO₂ protective layer may have an index of refraction at a 633 nm wavelength of from about 1.36 to about 1.56. In particular examples not part of the invention, the index of refraction of an SiO₂ protective layer is 1.46 ± 0.03 as measured by ellipsometry.

When the dielectric layer **24** includes silicon nitride, the dielectric layer **24** should have impurity levels at or below the levels shown in Table 1, as measured by secondary ion mass spectroscopy (SIMS) with a Cs ion beam.

**TABLE 1**

| Element | Concentration (cm⁻³) |
|---|---|
| H | 4X10²¹ |
| O | 3X10¹⁸ |
| C | 7X10¹⁷ |
| F | 1x10¹⁶ |
| Cl | 4x10¹⁶ |

The dielectric layer **24** may be blanket deposited on the barrier layer **22** and subsequently patterned as described below. Typically, the dielectric layer **24** may have a thickness in the range of about 100 nm, however, other thickness layers may also be utilized. For example, the dielectric layer should be sufficiently thick so as to protect the underlying layer during a subsequent anneal of ohmic contacts and/or implanted dopants. Layers as thin as two or three monolayers may be sufficient for such purposes. However, in general, the dielectric layer **24** may have a thickness of from about 10 nm to about 500 nm.

The dielectric layer may include a high purity SiN layer as described in U.S. Patent Application Serial No. 11/286,805 entitled "GROUP III NITRIDE SEMICONDUCTOR DEVICES WITH SILICON NITRIDE LAYERS AND METHODS OF MANUFACTURING SUCH DEVICES" filed November 23, 2005. In particular, pursuant to certain examples not part of the invention, an *in situ* grown SiN dielectric layer **24** may be grown using LPCVD or MOCVD at relatively high temperatures (e.g., above about 700 °C). In particular examples not part of the invention, the SiN layers may be grown at a temperature in the range of about 900 - 1000 °C. Such high temperature growth may also facilitate reducing the impurity levels in the SiN layer and at the interface between the barrier layer **22** and the SiN layer. Additionally, high growth rates may be employed which may facilitate reducing the levels of background reactor impurities incorporated into the SiN layer. For example, in certain examples not part of the invention, the SiN layer(s) may be grown at a growth rate of at least about 0.2 microns/hour. In some embodiments, the growth rate may be about 2 microns/hour.

Although the dielectric layer **24** can be formed *ex situ*, Forming the SiN dielectric layer **24** *in situ* may also reduce the levels of impurities that are incorporated into the top surface of the uppermost Group III nitride layer and/or into the SiN layer itself. In particular, when the device is removed from the reactor and the SiN layer is formed via a post-MOCVD growth process such as, for example, sputtering or PECVD, a number of different mechanisms may introduce impurities. For example, if hydrogen is present in an MOCVD reactor during the growth of a Group III nitride layer, the hydrogen may tend to incorporate into the Group III nitride layer during cooling of the reactor following growth. Likewise, exposure of the device to the atmosphere upon removal from the reactor may allow for incorporation of oxygen atoms, and various other impurities may be introduced, particularly adjacent the outer surfaces of the device, as a result of handling of the device and/or chemical cleaning of the device. Impurities may also be added if post-growth processing such as wet etching, electrode deposition, annealing steps, etc. are performed prior to deposition of the SiN protective/passivation layer. These impurities may change the surface states at the interface between the Group III nitride layer and the SiN layer in ways that may be undesirable and/or difficult to control/reproduce. For example, the presence of impurities can increase trapping at the interface between the SiN layer and the underlying Group III nitride layer, thereby potentially increasing the sheet resistance of the channel.

In some examples not part of the invention, high purity silane (SiH₄) may be used as a source gas in the growth of the SiN layer(s). As is known to persons of skill in the art, silane is often used as a source for silicon dopants in the growth of n-doped Group III nitride layers. Typically, diluted silane gas is used in such applications as it is less expensive and easier to use than pure silane, which may be highly combustible. The use of such pure silane may facilitate reducing the level of impurities at, for example, the interface between the Group III nitride layer and the SiN layer and/or within the SiN layer, which may, in certain circumstances, improve the performance and/or reproducibility of the device. In particular, the higher quality (i.e., more pure) SiN layer may help reduce or minimize trapping within the body of the insulative layer, thereby providing a higher breakdown critical field. When such a pure silane gas source is included with the reactor, it may still be desirable to include a diluted silane source as well, so that diluted silane gas may be used as the dopant gas source during the growth of, for example, an n-doped or co-doped Group III nitride layer.

Referring still to **Figure 1B****,** the dielectric layer **24** is patterned and etched using a mask **29** to expose surface portions **22A** of the barrier layer **22.** The dielectric layer **24** can be etched using, for example, a low damage etch process. Examples of low damage etch techniques include etching techniques other than reactive ion etching, such as inductively coupled plasma or electron cyclotron resonance (ECR) or downstream plasma etching with no DC component to the plasma. The mask **29** may include photoresist and/or a metal, and may be patterned using conventional photolithographic/liftoff techniques.

With the mask **29** in place, impurity ions **27** are implanted into the exposed surface portions **22A** of the barrier layer **22** such that at least a portion of the implanted ions come to rest within the channel layer **20.** In particular, the impurity ions **27** are implanted as shallow implants. As used herein, "shallow implants" means that the implants are made directly into the barrier layer with no capping or protective layer over the barrier layer during the implantation. The implanted ions are implanted with an implant energy and/or implant dose so that the peak of the implant profile is located near the interface between the channel layer **20** and the barrier layer **22** (or shallower), which is where the two dimensional electron gas (2DEG) **33** used for conductivity modulation is formed. For example, a "shallow" implant can include an implant directly into a barrier layer at low energy in a manner that can reduce both sheet resistance (R_{SH}) and lateral straggle for a given dose/energy. In some examples not part of the invention, the implanted ions form a concentration profile having a peak slightly within the channel layer **20** (e.g., within about 100 Å of the interface between the channel layer **20** and the barrier layer **22**). Accordingly, as shown in **Figure 1B**, implanted source/drain regions **31** may be formed partially within the barrier layer **22** and partially within the channel layer **20.**

As further shown in **Figure 1B**, since the source/drain regions **31** may be implanted using the same mask that was used to pattern the dielectric layer **24** or using the patterned dielectric layer **24** as an implantation mask, the dielectric layer **24** may be self-aligned to the source/drain regions **31.**

The implant conditions may be selected to provide implanted source/drain regions **31** having a peak dopant concentration of 1x10¹⁸ cm⁻³ or greater and a straggle of 50 nm or less. For example, in some examples not part of the invention, the dose and energy of the implants may be selected to provide a peak dopant concentration of about 5x10¹⁹ cm ⁻³ and a straggle of about 30 nm.

In some examples not part of the invention, the implants may be performed at room temperature. The implant energy and dose may be selected to provide an implant profile that achieves a desired sheet resistivity and/or permits fabrication of low resistivity ohmic contacts to the barrier layer **22**. In order to form n-type implanted source/drain regions **31** in a nitride-based layer, the implanted ions may include silicon, sulfur and/or oxygen ions. In some embodiments, the implantation may include a single implant step at an energy of about 40 to about 80 keV and a dose of 8x10¹⁴ to 1x10¹⁶ cm⁻². In particular embodiments, the implantation may include a single implant step at an energy of about 50 keV and a dose of about 5x10¹⁵ cm⁻². The implantation may be performed with the substrate **10** held at an angle of 7° to reduce/avoid channeling effects.

Using a single shallow implant with the implant peak near the 2DEG **33** may improve channel sheet resistance without adversely affecting the contact region in the source/drain regions **31.** Although the inventors do not wish to be bound by a particular theory, it appears that a shallow implant at relatively low energy may result in less damage to the semiconductor crystal in the barrier layer **22,** supporting the formation of low resistance ohmic contacts thereto.

Although a single implant is described above, the implant process may include multiple implant steps to provide a net profile of implanted dopants. For example, the implant process may include a first shallow implant step performed under a first set of implant conditions and a subsequent shallow implant step performed under a second set of implant conditions. More than two implant steps may be performed. Box profiles employing multiple energies may be used as long as the peak of the shallowest energy provides low contact resistance as with a single implant energy.

U.S. Patent Publication 2007/0158683 entitled " SEMICONDUCTOR DEVICES INCLUDING IMPLANTED REGIONS AND PROTECTIVE LAYERS AND METHODS OF FORMING THE SAME", published July 12, 2007 and which is assigned to the assignee of the present invention, discloses methods of forming source/drain regions by implanting ions through a protective layer formed on the barrier layer. The protective layer remains on the device to protect the barrier layer during activation annealing. However, the implant annealing energy, dose and/or anneal conditions used to implant the dopant ions through the protective layer can cause the dopant depth profile to extend farther into the channel layer than may be desirable.

Shallow implants for source drain regions are described, for example, in F. Recht, et al., "Nonalloyed ohmic contacts in AlGaN/GaN HEMTs by ion implantation with reduced activation annealing temperature," IEEE. Electron Device Letters, vol 27, no.4, (April 2006). The source/drain implants in the devices described by Recht et al. were annealed using a capless activation anneal (i.e. with no dielectric layer on the channel region during the activation anneal), and a SiN passivation layer was formed after implant activation anneal.

The devices of Recht et al. showed a contact resistance of 0.96 -mm to the channel. However, the channel region of the devices may suffer from higher sheet resistance and/or may exhibit higher gate leakage. Furthermore, the results may be less repeatable compared to methods according to examples not part of the invention. Use of shallow implants and protective layer during anneal can produce contact resistance values below 0.5 -mm with channel sheet resistance R_{SH} that are not significantly higher than as-grown R_{SH}.

A nitride transistor according to some examples not part of the invention includes both shallow source/drain implants and a protective dielectric layer **24** over the channel region. The dielectric layer **24,** which is formed on the channel region before the implant activation anneal, may protect the channel region during subsequent high temperature processing steps (e.g. activation anneal, ohmic contact anneal, etc.). However, because the dielectric layer **24** is not formed over at least portions of the source drain regions **31** during ion implantation, shallow source/drain implants may be performed. Furthermore, the dielectric layer **24** may remain on the barrier layer throughout the fabrication process, and may remain in the completed device. In some examples not part of the invention, the dielectric layer **24** is removed after the anneal, and a second dielectric layer is formed in its place. The second dielectric layer can include deposited SiN, for example.

Thus, according to some examples not part of the invention, openings are formed in the dielectric layer 24 above the source/drain regions **31** and dopants are directly implanted through the openings. Forming the source/drain regions **31** using shallow implants can provide an electrical conduction path to the device 2D electron gas **33.** That is, as a result of the direct shallow implanting of ions **27,** the resistance near the interface between the source/drain regions **31** and the 2DEG **33** may be reduced. Furthermore, the protection afforded by the dielectric layer **24** during a subsequent activation anneal may provide a lower sheet resistance channel region with reduced gate leakage.

After formation of the implanted source/drain regions **31,** the implants may be activated by an activation anneal. The activation anneal may be performed with the dielectric layer **24** in place. In particular, the dielectric layer **24** may protect the surface of the barrier layer **22** during the anneal.

The activation anneal may be performed in an inert atmosphere including, for example, N₂ and/or Ar. When the dielectric layer **24** includes SiN, the anneal atmosphere may include a partial pressure of NH₃ in the range of about 0.1 mbar to 1000 mbar. More particularly, the NH₃ may have a pressure of about 10 - 100 mbar. In particular, the NH₃ may have a pressure of about 90 mbar. The NH₃ may help to reduce decomposition of the SiN dielectric layer **24.** The activation anneal may be performed at a temperature sufficient to activate the implanted dopant ions but less than a temperature at which the underlying semiconductor layer, i.e. the barrier layer **22,** deteriorates. The presence of the dielectric layer **24** during the high temperature process steps may inhibit damage to the underlying epitaxial layers, including barrier layer **22,** that may otherwise result from high temperature annealing. For example, where the barrier layer **22** includes AlGaN, the activation anneal may be performed at a temperature greater than 1000 °C.

In some examples not part of the invention, SiH₄ may be provided in the annealing chamber during the implant anneal along with NH₃, in which case, SiN may be deposited on the dielectric layer **24** during the anneal.

In some examples not part of the invention, the activation anneal may be performed at a temperature of about 1000 °C to about 1300 °C. The activation anneal may be performed *in-situ* and/or in a separate annealing chamber. The activation anneal may be performed for at least about 30 seconds or more, depending on the anneal temperature. For example, a rapid thermal anneal (RTA) at about 1300 °C may be performed for about 30 seconds, while a furnace anneal at about 1000 °C may be performed for about 30 minutes. The particular selection of activation times and temperatures may vary depending on the type of materials involved and the particular implant conditions employed. In particular examples not part of the invention, the anneal time may be in the range of about 30 seconds to about 30 minutes.

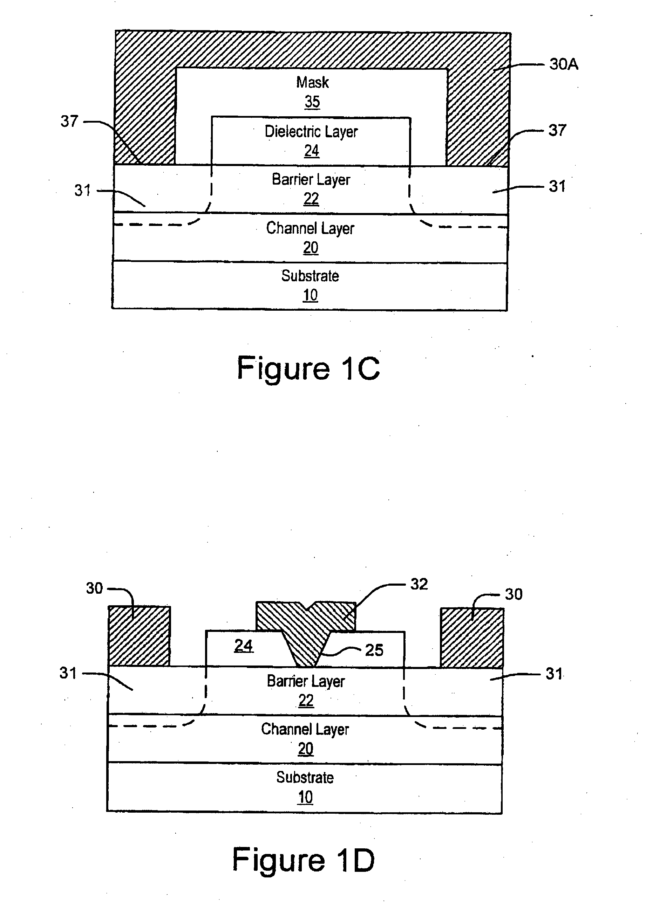

As illustrated in **Figure 1C**, a mask **35** is formed on the protective layer, and windows are then opened in the mask **35** over source/drain contact regions **37** for the formation of ohmic contacts. The mask **35** may include SiO₂, metal, photoresist or any other suitable mask material. The mask may have a thickness of about 0.1 to about 0.5 µm or more. In particular examples not part of the invention, an SiO₂ mask can have a thickness of about 0.5 µm, while a metal mask can have a thickness of about 0.4 µm.

A metal overlayer **30A** may then be deposited, for example by evaporation, on the mask **35** and on the portions of the barrier layer **22** exposed by the mask **35** to provide the ohmic contacts **30.** Suitable metals may include Ti, Si, Ni, Au, Al, Ta, Mo, TiN, WSiN, and/or Pt. In particular examples not part of the invention, the metal overlayer **30A** can include a stack of Ti (250 Å), Al (1000 Å) and Ni (500 Å) formed in order on the substrate. The mask **35** may then be lifted off, leaving ohmic contacts **30** on the source drain regions **31 (****Figure 1D****)**.

The edges of the ohmic contacts **30** may be spaced apart laterally on the surface of the barrier layer **22** from the dielectric layer **24** by a distance corresponding to the lateral thickness of the mask **35.** For example, the edges of the ohmic contacts **30** may be spaced apart laterally from the dielectric layer **24** by a distance in the range of about 0.1 to about 0.5 µm, and in particular examples not part of the invention by about 0.25 µm. The ohmic contacts **30** may be spaced apart from the dielectric layer **24** a distance sufficiently large to allow for misalignment tolerances in the formation and patterning of the ohmic contact metal. If the ohmic contact metal contacts the dielectric layer **24,** the metal may diffuse into the dielectric layer **24** during subsequent heating steps, which may result in a short between a gate contact and the ohmic contact(s) **30.** However, the gap between the ohmic contacts **30** and the dielectric layer **24** should not be so large as to defeat the protective purpose of the dielectric layer **24** and, thereby, substantially degrade the performance of the device but should not be so small to risk random contact of ohmic material to the protective layer. Thus, for example, in certain examples not part of the invention, the gap between the ohmic contacts **30** and the dielectric layer **24** may be from about 0.1 µm to about 0.5 µm.

Following metal evaporation, the mask **35** is removed, leaving the ohmic contacts **30** in place.

In some examples not part of the invention, the deposited metal may be annealed to reduce the contact resistance of the ohmic contacts **30.** The anneal may be a low temperature anneal. For example, the anneal may be an anneal at a temperature less than about 800 °C in an atmosphere of an inert gas such as N₂ or Ar. For example, the ohmic contacts 30 may be annealed at a temperature of about 450 °C to about 700 °C, and in further examples not part of the invention at a temperature of about 570 °C to about 580 °C.

Through the use of an ohmic contact anneal, the resistance of the ohmic contacts may be reduced from a relatively high resistance to about 1 Ω-mm or less. Thus, as used herein, the term "ohmic contact" refers to a non-rectifying contact that has a contact resistance of about 1 Ω-mm or less. As with the implant activation anneal, the presence of the dielectric layer **24** during the high temperature process steps may reduce or prevent damage to the barrier layer **22** that may otherwise be caused by such steps. Thus, for example, the sheet resistance of the gate region **21** after the high temperature ohmic contact anneal may be substantially the same as the sheet resistance of the gate region **21** as-grown (i.e. before the contact anneal).

It will be appreciated, however, that due to the presence of the implanted regions **31** as provided above, it may not be necessary to anneal the deposited metal in order to form an ohmic contact thereto. That is, the metal-semiconductor junction may be ohmic as deposited. Since a contact anneal may not be required, it may be acceptable for the metal of the ohmic contacts **30** to contact the dielectric layer **24.** Thus, in some examples not part of the invention a lithography step that may otherwise be required in order to ensure that the ohmic contacts **30** are spaced away from the dielectric layer **24** may be avoided as a result of the implantation of impurities into the barrier layer **22.**

In addition, since the ohmic contacts **30** are formed on the implanted regions 31, the ohmic contacts **30** may have a lower resistivity than ohmic contacts formed on non-implanted regions. Thus, the on-resistance of devices formed according to some embodiments of the invention may be lowered.

The formation of low resistance ohmic contacts in GaN HEMTs may help improve the performance of power amplifiers at mm-wave frequencies, as well as other applications that require low on-resistance, including, for example, RF power switches, limiters, and cascode cells. For typical transistor applications, reducing the contact resistance of the device may permit an increase in the drain-source spacing without increasing the on-resistance of the device. Furthermore, the gain and efficiency of microwave devices can be improved through reductions in resistance.

**Figure 1D** further illustrates the formation of a gate contact **32.** A mask (not shown) is formed on the ohmic contacts **30** and the dielectric layer **24** and patterned to form a window that exposes a portion of the dielectric layer **24.** A recess **25** is then formed through the dielectric layer **24** to expose a portion of the barrier layer **22.** The recess **25** may be formed using a low damage etch process, such as inductively coupled plasma or electron cyclotron resonance (ECR) or downstream plasma etching with no DC component to the plasma.

In particular examples not part of the invention where the ohmic contacts **30** provide source and drain contacts, the recess may be offset between the source and drain contacts such that the recess, and subsequently the gate contact **32,** is closer to the source contact than the drain contact.

As seen in **Figure 1D**, a gate contact **32** is formed in the recess and contacts the exposed portion of the barrier layer **22.** The gate contact may be a "T" gate as illustrated in **Figure 1D** and may be fabricated using conventional fabrication techniques. Suitable gate materials may depend on the composition of the barrier layer, however, in certain examples not part of the invention, conventional materials capable of making a Schottky contact to a nitride based semiconductor material may be used, such as Ni, Pt, NiSiₓ, Cu, Pd, Cr, W and/or WSiN. Although it may be undesirable, it is possible that a small gap between the dielectric layer **24** and the gate contact **32** may arise as a result of, for example, anisotropy of the low-damage etch, resulting in an exposed surface of the barrier layer **22** between the dielectric layer **24** and the gate contact **32.**

In some examples not part of the invention, since the source/drain contacts may not need to be annealed, it may be possible to form the source and drain contacts using the same metal in a single metallization step. For example, Ti, Si, Ni, Au, Al, Ta, Mo, TiN, WSiN, and/or Pt may form an ohmic contact as-deposited on the doped regions **31** of the barrier layer **22** while forming a non-ohmic contact on other portions of the barrier layer **22.** A gate metal as described above can endure a thermal budget that includes temperatures as high as 350 °C. Thus, while it is possible to form source and drain contacts that are ohmic as-deposited, the thermal processing for subsequent processing of the device can include temperatures that may not negatively affect the gate contact, but that can improve the contact resistance of the source and drain contacts.

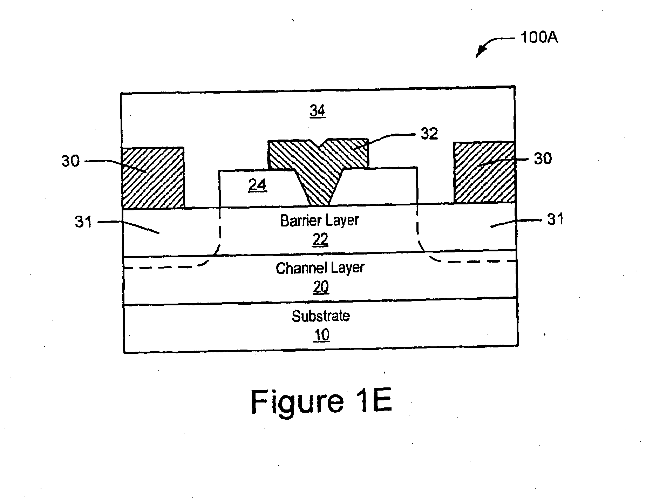

**Figure 1E** illustrates a completed device structure **100A** including a passivation layer **34.** The passivation layer **34** may be blanket deposited on the structure of **Figure 1D**. In particular examples not part of the invention, the passivation layer **34** is deposited so as to substantially fill the gap between the dielectric layer **24** and the ohmic contacts **30** and also any gap between the dielectric layer **24** and the gate contact **32,** if such gap(s) exist. In certain examples not part of the invention, the passivation layer **34** may include silicon nitride, aluminum nitride, silicon dioxide and/or an oxynitride. Furthermore, the passivation layer **34** may be a single or multiple layers of uniform and/or non-uniform composition.

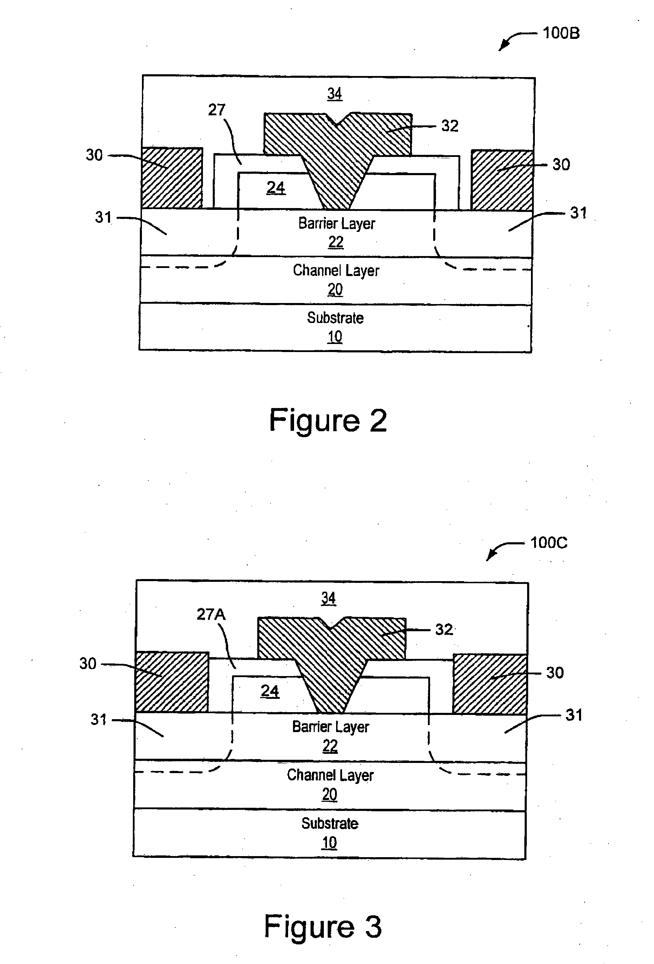

Embodiments of the present invention are illustrated in **Figures 2 and 3**. As shown therein, a device structure **100B, 100C** according to embodiments of the invention includes a second dielectric layer **27** on the dielectric layer **24**. The second dielectric layer **27** can be formed before or after annealing the implanted regions **31** and before formation of the gate contact **32**. The second dielectric layer **27** can be formed of similar materials as the dielectric layer **24**, and can include SiN, SiO₂, SiON, AlSiN and/or any other suitable dielectric material, and can be provided to protect exposed portions of the implanted source/drain regions **31** during high temperature processing steps. As shown in **Figures 2**, the second dielectric layer **27** can be spaced apart laterally from the ohmic contacts **30**. In particular, the second dielectric layer **27** can be laterally spaced apart form the ohmic contacts by about 0.25µm. Alternatively, as shown in **Figure 3**, the second dielectric layer **27A** can be in direct contact with the ohmic contacts **30**.

The second dielectric layer **27** is formed of a material different from the dielectric layer **24**. For example, in some embodiments, the dielectric layer **24** comprises SiN, while the second dielectric layer **27** comprises SiO₂, AlSiN and/or SiON.

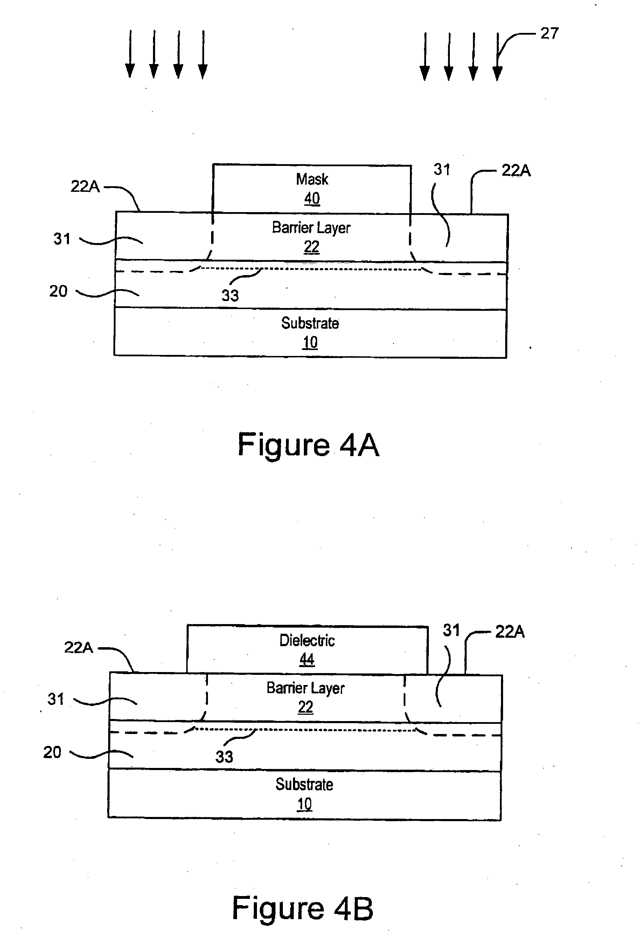

**Figures 4A** and **4B** illustrate further embodiments in which a dielectric layer **44** is formed on the barrier layer **22** after implanting the ions **27**. Referring to **Figure 4A**, a mask **40 is** formed on the barrier layer **22**. The mask **40** may include a dielectric material such as SiN, SiO₂, AlSiN and/or SiON. The dielectric mask **40** is patterned to expose surface areas **22A** above the source and drain regions **31** of the device. Impurity ions **27** are implanted into the exposed surfaces **22A** to form the implanted source and drain regions **31**.

In embodiments in which the mask **40** includes a dielectric material such as SiN, SiO₂, AlSiN and/or SiON, the implants, may be annealed as described above before removing the mask **40**.

Referring to **Figure 4B**, the mask **40** is removed, and the dielectric layer **44** is formed on the upper surface of the device structure (e.g. on the barrier layer **22**) and patterned to expose at least portions of the source and drain regions **31**. The dielectric layer **44** can include, for example, SiN, SiO₂, AlSiN and/or SiON. In particular embodiments, the dielectric layer **44** can inclutle deposited SiN. It will be appreciated that it may be desirable to clean the upper surface of the device structure before forming the dielectric **layer 44** thereon. The cleaning process may include a fluorine-based clean, such as HF (concentrated for high-purity nitride), a buffered oxide etch (BOE) or a fluorine-based dry etch, such as a dry etch using CF₄, SF₆, CHF₃, etc. An RCA, Ar sputter and/or oxygen plasma cleaning process can also be used.

In some embodiments, the implanted ions may be annealed after formation of the dielectric layer **44** so that the dielectric layer **44** is in place during the anneal. Furthermore, the implanted ions may be annealed before or after patterning the dielectric layer **44** to expose contact regions of the source and drain regions **31**.

Embodiments of the invention may allow the use of a lower anneal temperature and/or lower implant energies compared to methods that implant ions through a dielectric layer. Furthermore, the resulting device may have lower channel layer sheet resistance, lower resistance at the interface between the 2DEG region **33** and the implanted source/drain regions **31** and/or lower gate leakage. In some embodiments, the channel layer sheet resistance increase due to subsequent processing steps may be less than about 5%.

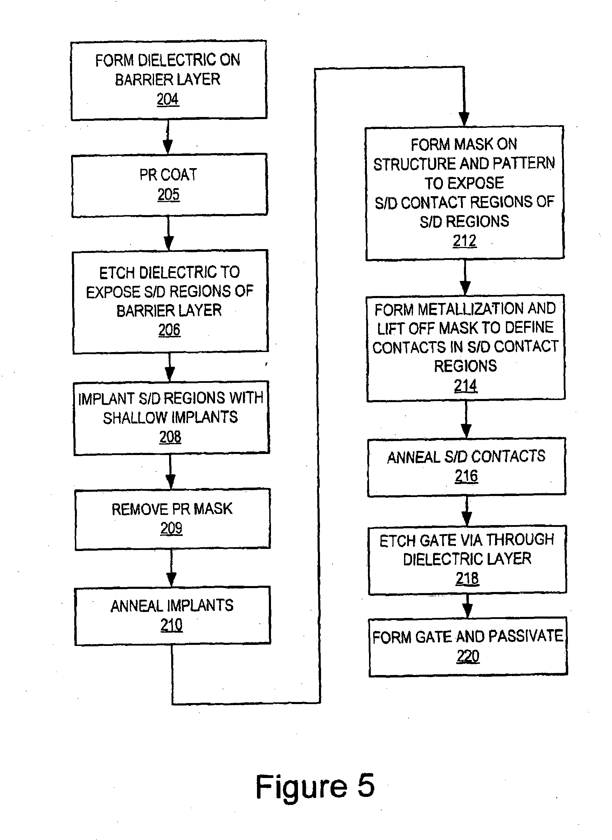

**Figures 5-7** are flowcharts illustrating operations. In particular, **Figure 5** is a flowchart illustrating operations for forming a device including a single dielectric layer **24** that is formed before implantation of the source/drain regions **31**.

Referring to **Figure 5**, a dielectric layer **24** is formed on a barrier layer **22** of a GaN-based HEMT structure (Block **204**). The wafer is coated with photoresist (Block **205**). An etch mask is formed, and the dielectric layer **24** is etched to expose the source/drain regions **31** of the barrier layer **22** (Block **206**). The source/drain regions **31** are then implanted with shallow implants (Block **208**). The photoresist is then removed (Block **209**), and the implanted ions are then annealed for electrical activation (Block **210**).

A mask, such as a photoresist mask **35**, is then formed on the structure and patterned to expose source/drain contact regions **37** of the source/drain regions **31** (Block **212**). Metal is then evaporated onto the structure, and the mask **35** is lifted off to define contacts in the source/drain contact regions **37** (Block **214**). The source/drain contacts may then be annealed (Block **216**). Next, a gate via **25** is etched through the dielectric layer **24**, for example using a photoresist etch mask (Block **218**). A gate **32** is then formed in the gate via **25**, and the entire structure is passivated with a passivation layer **34** (Block **220**).

As discussed above, it may be possible to form the source/drain contacts **30** and the gate contact **32** in the same steps in cases in which the source and drain contacts **30** are ohmic as deposited.

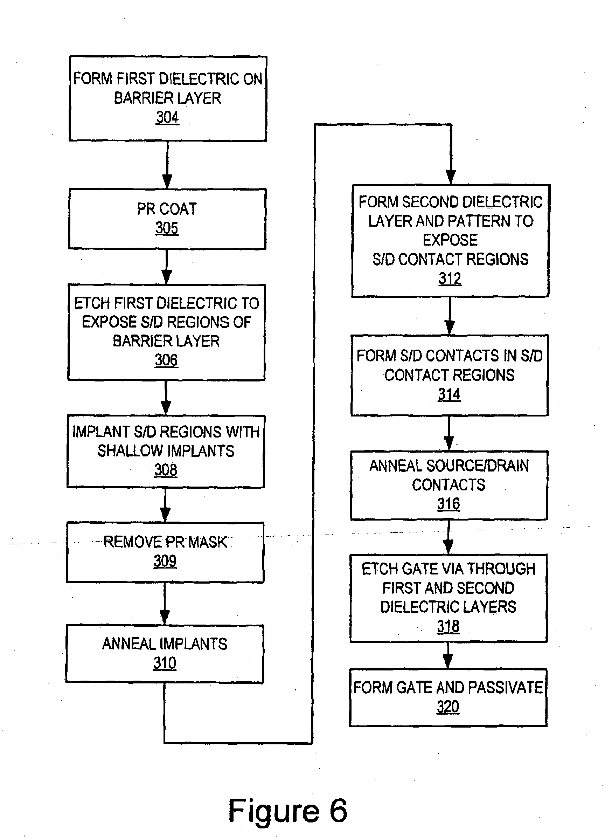

**Figure 6** is a flowchart illustrating operations according to some embodiments for forming a device including a dielectric layer **24** that is formed before implantation of the source/drain regions **31** and a second dielectric layer **27** that is formed after implantation of the source/drain regions **31.**

Referring to **Figure 6****,** a first dielectric layer **24** is formed on a barrier layer **22** of a GaN-based HEMT structure (Block **304**). The wafer is coated with photoresist (Block **305**). An etch mask is formed, and the dielectric layer **24** is etched to expose the source/drain regions **31** of the barrier layer **22** (Block **306**). The source/drain regions **31** are then implanted with shallow implants (Block **308**). The photoresist is then removed (Block **309**), and the implanted ions are then annealed for electrical activation (Block **310**).

A second dielectric layer **27** is then formed on the structure over the first dielectric layer **27** and the source/drain regions **31** (Block **312**). The second dielectric layer **27** is patterned using a photoresist mask to extend onto the source/drain regions **31** and expose at least the source/drain contact regions **37** of the source/drain regions **31.** In some embodiments, a separate photolithography step may be performed to deposit and pattern a second photoresist mask to define the source/drain contact regions **37.**

Metal is then evaporated onto the structure, and the photoresist mask is lifted off to define contacts in the source/drain contact regions **37** (Block **314**). The source/drain contacts may then be annealed (Block **316**). Next, a gate via **25** is etched through the dielectric layer **24,** for example using a photoresist etch mask (Block **318**). A gate **32** is then formed in the gate via **25,** and the entire structure is passivated with a passivation layer **34** (Block **320**).

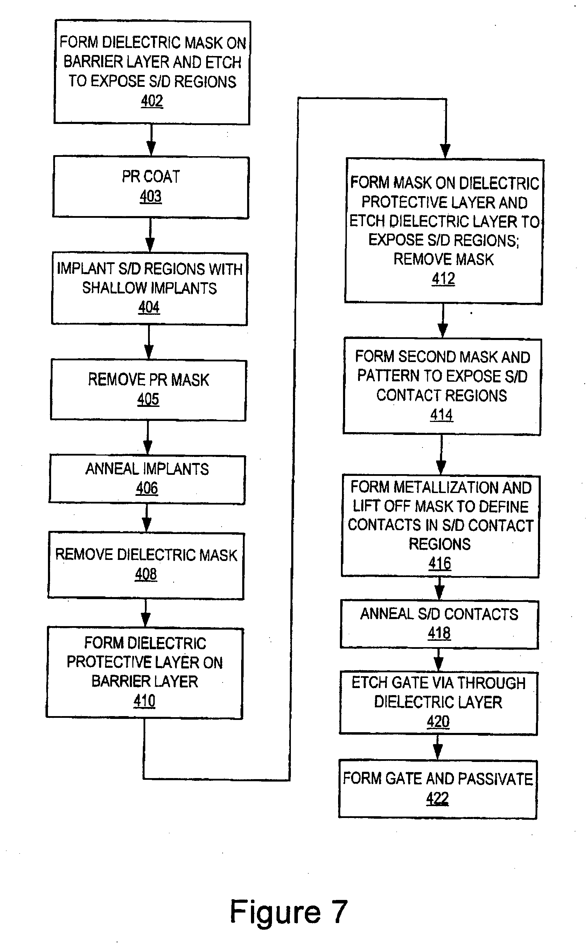

**Figure 7** is a flowchart illustrating operations according to some embodiments for forming a device including a single dielectric layer **44** that is formed after implantation of the source/drain regions **31.**

Referring to **Figure 7****,** a dielectric implant mask **40** is formed on a barrier layer **22** of a GaN-based HEMT structure (Block **402**). The wafer is coated with photoresist (Block **403**). The mask is patterned to expose the source/drain regions **31** of the barrier layer **22.** The source/drain regions **31** are then implanted with shallow implants (Block **404**). The photoresist is then removed (Block **405**), and the implanted ions are then annealed for electrical activation (Block **406**).

The dielectric implant mask **40** is removed (Block **408**), and a dielectric protective layer **44** is formed on the barrier layer (Block **410**).

A mask is then formed on the dielectric layer **44,** and the dielectric layer is etched to expose the source/drain regions **31** (Block **412**). In some embodiments, the dielectric layer **44** may be etched to expose the source/drain regions **31** before the implanted ions are annealed.

A second mask is formed and patterned to expose the source/drain contact regions **37** of the source/drain regions **31** (Block **414**). Metal is then evaporated onto the structure, and the second mask is lifted off to define contacts in the source/drain contact regions **37** (Block **416**). The source/drain contacts may then be annealed (Block **418**). Next, a gate via **25** is etched through the dielectric layer **44,** for example using a photoresist etch mask (Block **420**). A gate **32** is then formed in the gate via **25,** and the entire structure is passivated with a passivation layer **34** (Block **422**).

## Claims

1. A method of forming a semiconductor device, comprising:
forming a first dielectric layer (24, 40) on a Group III-nitride semiconductor layer (22);
selectively removing portion of the first dielectric layer over spaced apart source and drain regions (31) of the semiconductor layer;
annealing the semiconductor layer and the first dielectric layer to activate the implanted ions;
forming metal contacts (30) on the source and drain regions of the semiconductor layer;
forming a second dielectric layer (27, 44) over the first dielectric layer after implanting the source and drain regions; and
selectively removing portions of the second dielectric layer in the source and drain regions to expose respective source and drain contact regions in the source and drain regions.

2. The method of claim 1, wherein the ions (27) are implanted at an implant energy less than 80 keV and a dose of 8x10¹⁴ ions/cm² to 1x10¹⁶ ions/cm².

3. The method of claim 1 or claim 2, wherein the implantation energy is selected to provide a peak implant concentration near an interface of the semiconductor layer (22) and a channel layer (20) underlying the semiconductor layer.

4. The method of claim 3, wherein the peak implant concentration is within 100Å of the interface of the semiconductor layer and the channel layer.

5. The method of claim 3, wherein the peak implant concentration is greater than 1x10²⁰ cm⁻³, preferably greater than 3x10²⁰ cm⁻³.

6. The method of any preceding claim, further comprising forming source and drain contacts in the source and drain contact regions, wherein the source and drain contacts are in direct contact with the second dielectric layer.

7. The method of any preceding claim, the method further comprising:
removing the first dielectric layer (40) before forming the second dielectric layer.

8. The method of any preceding claim, wherein forming the metal contacts comprises:
forming a mask over the second dielectric layer and the source and drain regions;
selectively removing portions of the mask to expose the source and drain contact regions;
depositing a metal on the source and drain contact regions; and removing the mask.

9. The method of any preceding claim, wherein the first dielectric layer (24) comprises SiN.

10. The method of claim 9, wherein annealing the semiconductor layer and the first dielectric layer comprises annealing in NH₃ and SiH₄ so that SiN is formed on the dielectric layer during the anneal.

11. The method of claim 9 or claim 10, wherein forming the first dielectric layer comprises forming the first dielectric layer using LPCVD or MOCVD at a temperature greater than 700°C.

12. The method of claim 9, wherein forming the first dielectric layer comprises forming the dielectric layer at a temperature of 900°C to 1000°C.

13. The method of claim 7 or claim 8, wherein the first dielectric layer is a first silicon nitride layer, wherein the second dielectric layer is a second silicon nitride layer, the method further comprising:
annealing the metal contacts;
etching a via through the second silicon nitride layer; and
forming a gate contact in the via.

14. A transistor device (100B, 100C) comprising:
a Group-III nitride semiconductor layer (22) including an upper surface and spaced apart source and drain regions in the upper surface;
a first dielectric protective layer (24) on the upper surface of the semiconductor layer;
a second dielectric layer (27), formed of a material different from the first dielectric protective layer, formed over the first dielectric layer and patterned to expose respective source and drain contact regions in the source and drain regions;
a gate contact (32) on a surface of the dielectric protective layer opposite the Group III-nitride semiconductor layer and extending through the dielectric protective layer to contact the Group-III nitride semiconductor layer (22);
a distribution of implanted dopants within the source and drain regions (31) of the semiconductor layer; and
source and drain ohmic contacts (30) on the source and drain regions, respectively, of the semiconductor layer, wherein the source and drain ohmic contacts are spaced apart laterally from the first dielectric protective layer by 0.1µm to 1 µm.

15. The transistor device of claim 14, wherein the Group-III-nitride semiconductor layer comprises a barrier layer, the device further comprising a channel layer on the barrier layer opposite the gate contact, wherein the distribution of implanted dopants has a peak concentration near an interface of the channel layer and the barrier layer.

## Patentansprüche

1. Verfahren zur Bildung einer Halbleitervorrichtung, wobei das Verfahren die folgenden Schritte umfasst:
Bilden einer ersten dielektrischen Schicht (24, 40) auf einer Halbleiterschicht (22) aus Nitrid der Gruppe III;
selektives Entfernen eines Abschnitts der ersten dielektrischen Schicht über voneinander beabstandeten Source- und Drainzonen (31) der Halbleiterschicht;
Tempern der Halbleiterschicht und der ersten dielektrischen Schicht zur Aktivierung der implantierten lonen;
Bilden von Metallkontakten (30) auf den Source- und Drainzonen der Halbleiterschicht;
Bilden einer zweiten dielektrischen Schicht (27, 44) über der ersten dielektrischen Schicht nach Implantierung der Source- und Drainzonen; und
selektives Entfernen von Abschnitten der zweiten dielektrischen Schicht in den Source- und Drainzonen zur Freilegung jeweiliger Source- und Drain-Kontaktzonen in den Source- und Drainzonen.

2. Verfahren nach Anspruch 1, wobei die Ionen (27) mit einer Implantationsenergie geringer als 80 keV und in einer Dosierung von 80x10¹⁴ Ionen/cm² bis 1x10¹⁶ Ionen/cm² implantiert werden.

3. Verfahren nach Anspruch 1 oder Anspruch 2, wobei die Implantationsenergie so gewählt wird, dass eine Spitzen-Implantatkonzentration in der Nähe einer Schnittstelle bzw. eines Grenzbereichs der Halbleiterschicht (22) mit einer Kanalschicht (20), welche unter der Halbleiterschicht liegt, bereitgestellt wird.

4. Verfahren nach Anspruch 3, wobei die Spitzen-Implantatkonzentration innerhalb 100 Å der Schnittstelle bzw. des Grenzbereichs der Halbleiterschicht mit der Kanalschicht liegt.

5. Verfahren nach Anspruch 3, wobei die Spitzen-Implantatkonzentration größer als 1x10²⁰ cm⁻³, vorzugsweise größer als 3x10²⁰ cm⁻³ ist.

6. Verfahren nach einem der vorhergehenden Ansprüche, welches des Weiteren die Ausbildung der Source- und Drainkontakte in den Source- und Drain-Kontaktzonen aufweist, wobei die Source- und Drain-Kontakte in direktem Kontakt mit der zweiten dielektrischen Schicht sind.

7. Verfahren nach einem der vorhergehenden Ansprüche, wobei das Verfahren des Weiteren den folgenden Schritt umfasst:
Entfernen der ersten dielektrischen Schicht (40) vor der Ausbildung der zweiten dielektrischen Schicht.

8. Verfahren nach einem der vorhergehenden Ansprüche, wobei die Ausbildung der Metallkontakte die folgenden Schritte umfasst:
Ausbildung einer Maske über der zweiten dielektrischen Schicht und den Source-und Drainzonen;
selektives Entfernen von Abschnitten der Maske zur Freilegung der Source- und Drain-Kontaktzonen;
Abscheiden eines Metalls auf die Source- und Drain-Kontaktzonen; und Entfernen der Maske.

9. Verfahren nach einem der vorhergehenden Ansprüche, wobei die erste dielektrische Schicht (24) SiN aufweist.

10. Verfahren nach Anspruch 9, wobei das Tempern der Halbleiterschicht und der ersten dielektrischen Schicht das Tempern in NH₃ und SiH₄ umfasst, so dass SiN auf der dielektrischen Schicht während des Tempervorgangs ausgebildet wird.

11. Verfahren nach Anspruch 9 oder Anspruch 10, wobei die Ausbildung der ersten dielektrischen Schicht die Ausbildung der ersten dielektrischen Schicht unter Verwendung eines Tiefdruck-CVD-Verfahrens (LPCVD) oder eines metallorganischen CVD-Verfahrens (MOCVD) bei einer Temperatur größer als 700°C umfasst.

12. Verfahren nach Anspruch 9, wobei die Ausbildung der ersten dielektrischen Schicht die Ausbildung der dielektrischen Schicht bei einer Temperatur von 900°C bis 1000°C umfasst.

13. Verfahren nach Anspruch 7 oder Anspruch 8, wobei die erste dielektrische Schicht eine erste Siliziumnitridschicht ist, wobei die zweite dielektrische Schicht eine zweite Siliziumnitridschicht ist, wobei das Verfahren des Weiteren die folgenden Schritte umfasst:
Tempern der Metallkontakte;
Ätzen einer Durchkontaktierung durch die zweite Siliziumnitridschicht; und
Bilden eines Gate-Kontakts in der Durchkontaktierung.

14. Transistorvorrichtung (100B, 100C), welche Folgendes aufweist:
eine Halbleiterschicht (22) aus Nitrid der Gruppe III einschließlich einer oberen Fläche und voneinander beabstandeter Soure- und Drainzonen in der oberen Fläche;
eine erste dielektrische Schutzschicht (24) auf der oberen Fläche der Halbleiterschicht;
eine zweite dielektrische Schicht (27), welche aus einem zu dem Werkstoff der ersten dielektrischen Schutzschicht unterschiedlichen Werkstoff gebildet ist, wobei die zweite dielektrische Schicht über der ersten dielektrischen Schicht gebildet ist und mit einem Muster versehen ist, um jeweilige Source- und Drain-Kontaktzonen in den Source- und Drainzonen freizulegen;
einen Gate-Kontakt (32), welcher auf einer Oberfläche der dielektrischen Schutzschicht gegenüber der Halbleiterschicht aus Nitrid der Gruppe III angeordnet ist und welcher sich durch die dielektrische Schutzschicht erstreckt, um die Halbleiterschicht (22) aus Nitrid der Gruppe III zu kontaktieren;
eine Verteilung implantierter Dotierstoffe innerhalb der Source- und Drainzonen (31) der Halbleiterschicht; und
ohmsche Source- und Drainkontakte (30) auf den Source- bzw. Drainzonen der Halbleiterschicht, wobei die ohmschen Source- und Drainkontakte seitlich von der ersten dielektrischen Schutzschicht 0,1µm bis 1µm beabstandet sind.

15. Transistorvorrichtung nach Anspruch 14, wobei die Halbleiterschicht aus Nitrid der Gruppe III eine Sperrschicht aufweist, wobei die Vorrichtung darüber hinaus eine Kanalschicht auf der Sperrschicht gegenüber dem Gate-Kontakt aufweist, wobei die Verteilung der implantierten Dotierstoffe eine Spitzenkonzentration in der Nähe einer Schnittstelle bzw. eines Grenzbereichs der Kanalschicht mit der Sperrschicht aufweist.

## Revendications

1. Procédé de formation d'un dispositif semiconducteur, comprenant :
former une première couche diélectrique (24, 40) sur une couche semi-conductrice de nitrure de Groupe III (22) ;
retirer sélectivement une portion de la première couche diélectrique sur des régions de source et de drain espacées (31) de la couche semi-conductrice ;
recuire la couche semi-conductrice et la première couche diélectrique pour activer les ions implantés ;
former des contacts métalliques (30) sur les régions de source et de drain de la couche semi-conductrice ;
former une deuxième couche diélectrique (27, 44) sur la première couche diélectrique après l'implantation des régions de source et de drain ; et
retirer sélectivement des portions de la deuxième couche diélectrique dans les régions de source et de drain pour exposer des régions de contact de source et de drain dans les régions de source et de drain.

2. Procédé selon la revendication 1, dans lequel les ions (27) sont implantés à une énergie d'implantation inférieure à 80 keV et une dose de 8x10¹⁴ ions/cm² à 1x10¹⁶ ions/cm².

3. Procédé selon la revendication 1 ou la revendication 2, dans lequel l'énergie d'implantation est sélectionnée pour réaliser une concentration d'implantation de crête près d'une interface de la couche semi-conductrice (22) et une couche de canal (20) située sous la couche semi-conductrice.

4. Procédé selon la revendication 3, dans lequel la concentration d'implantation de crête est dans les 100Å de l'interface de la couche semi-conductrice et de la couche de canal.

5. Procédé selon la revendication 3, dans lequel la concentration d'implantation de crête est plus grande que 1x10²⁰ cm⁻³, de préférence plus grande que 3x10²⁰ cm⁻³.

6. Procédé selon l'une quelconque des revendications précédentes, comprenant en outre la formation de contacts de source et de drain dans les régions de contact de source et de drain, où les contacts de source et de drain sont en contact direct avec la deuxième couche diélectrique.

7. Procédé selon l'une quelconque des revendications précédentes, le procédé comprenant en outre :
retirer la première couche diélectrique (40) avant de former la deuxième couche diélectrique.

8. Procédé selon l'une quelconque des revendications précédentes, dans lequel la formation des contacts métalliques comprend :
former un masque sur la deuxième couche diélectrique et les régions de source et de drain ;
retirer sélectivement des portions du masque pour exposer les régions de contact de source et de drain ;
déposer un métal sur les régions de contact de source et de drain ; et retirer le masque.

9. Procédé selon l'une quelconque des revendications précédentes, dans lequel la première couche diélectrique (24) comprend SiN.

10. Procédé selon la revendication 9, dans lequel le recuit de la couche semi-conductrice et de la première couche diélectrique comprend le recuit dans NH₃ et SiH₄ de sorte que SiN est formé sur la couche diélectrique durant le recuit.

11. Procédé selon la revendication 9 ou la revendication 10, dans lequel la formation de la première couche diélectrique comprend la formation de la première couche diélectrique en utilisant LPCVD ou MOCVD à une température supérieure à 700 °C.

12. Procédé selon la revendication 9, dans lequel la formation de la première couche diélectrique comprend la formation de la couche diélectrique à une température de 900 °C à 1000°C.

13. Procédé selon la revendication 7 ou la revendication 8, dans lequel la première couche diélectrique est une première couche de nitrure de silicium, où la deuxième couche diélectrique est une deuxième couche de nitrure de silicium, le procédé comprenant en outre :
recuire les contacts métalliques ;
graver un passage à travers la deuxième couche de nitrure de silicium ; et
former un contact de grille dans le passage.

14. Dispositif transistor (100B, 100C) comprenant :
une couche semi-conductrice de nitrure de Groupe-III (22) incluant une surface supérieure et des régions de source et de drain espacées dans la surface supérieure ;
une première couche de protection diélectrique (24) sur la surface supérieure de la couche semi-conductrice ;
une deuxième couche diélectrique (27), réalisée en un matériau différent de la première couche de protection diélectrique, formée sur la première couche diélectrique et à motifs pour exposer des régions de contact de source et de drain respectives dans les régions de source et de drain ;
un contact de grille (32) sur une surface de la couche de protection diélectrique opposée à la couche semi-conductrice de nitrure de Groupe III et s'étendant à travers la couche de protection diélectrique pour venir en contact avec la couche semi-conductrice de nitrure de Groupe III (22) ;
une distribution de dopants implantés dans les régions de source et de drain (31) de la couche semi-conductrice ; et
des contacts ohmiques de source et de drain (30) sur les régions de source et de drain, respectivement, de la couche semi-conductrice, où les contacts ohmiques de source et de drain sont espacés latéralement de la première couche de protection diélectrique de 0,1 µm à 1 µm.

15. Dispositif transistor selon la revendication 14, dans lequel la couche semi-conductrice de nitrure de Groupe III comprend une couche barrière, le dispositif comprenant en outre une couche de canal sur la couche barrière opposée au contact de grille, où la distribution de dopants implantés présente une concentration de crête près d'une interface de la couche de canal et de la couche barrière.
